# EUROPEAN PATENT SPECIFICATION

(11) **EP 1 892 835 B1**
(45) Date of publication and mention of the grant of the patent: **22.10.2008**
(21) Application number: 06017521.3
(22) Date of filing: 23.08.2006
(51) Int. Cl.: H03J 1/00

(54) **Car radio system and method for selecting and displaying radio stations**
Autoradioanlage und Verfahren zum Auswählen und Anzeigen von Funkstationen
Systeme d'autoradio et procédé pour sélectionner et afficher de stations radio

(43) Date of publication of application: 27.02.2008
(73) Proprietor: Harman Becker Automotive Systems GmbH, 76307 Karlsbad (DE)
(72) Inventor: Kolletzki, Johannes, 90542 Eckental (DE)
(74) Representative: Bertsch, Florian Oliver

(56) References cited:
- EP-A1- 0 095 564
- EP-A1- 0 708 528
- US-A1- 2002 068 536
- US-B1- 6 289 207

## Description

The present invention relates to a car radio system comprising a radio tuner device for receiving a plurality of different radio stations each having a specific signal strength, and a radio station selection device for selecting radio stations with a signal strength above a predetermined threshold and for displaying the selected radio stations on a display.

Car radio systems of the afore-mentioned kind are generally known. The applicant of the present application for example offers such car radio systems under the brand name "Becker". Current car radio systems have the ability to display the name of a received radio station rather than displaying the frequency of the radio station only. This function is generally known as RDS and uses information transmitted with the radio signal. The RDS function now allows to display the radio station names on the display so that the user of the car radio system may select one of the displayed radio stations in a very convenient manner.

Generally, the received radio stations differs with respect to their signal strength in a wide range from high signal strength resulting in a good reception quality to a low signal strength resulting in a poor reception quality. Due to the fact that the user normally does not select radio stations with poor reception quality, the car radio system is adapted to filter the display of selectable radio stations. That is in other words that the car radio system displays only those radio stations on the display which have a good reception quality, i.e. a signal strength above a predetermined threshold. Hence, the car radio system does not offer the radio stations having a poor reception quality for selection by the user.

EP-A-095 564 describes a car radio according to the preamble of claim 1.

Although these car radio systems have proved to be good, reliable and ergonomic in practice, there is always a need and demand for further improvements, particularly with respect to the operation of the car radio system.

In view of the above, it is therefore an object of the present invention to provide a car radio system which may be operated by the user more easily and which allows to be adapted to the user's requirements in a greater extent.

This object is solved by the car radio system of the afore-mentioned kind by providing a threshold-adjusting device allowing to adjust the threshold manually.

That is in other words that the user of the car radio system may adjust the threshold as to increase or reduce the number of radio stations displayed for selection. Hence, the car radio system may be better adapted to the demands of the user. Particularly, users accepting only radio stations with a high signal strength may set a high threshold value, whereas users accepting also radio stations with a low signal strength may set the threshold on a low value. Dependent on the set threshold, the radio station selection device displays the name of the respective radio stations for selection by the user.

Hence, the advantage of the present invention is a further improvement with respect to operation and adaptation of the car radio system.

In a preferred embodiment, the threshold-adjustment device is assigned a control element to allow step-adjustment of the threshold between a lower limit and an upper limit.

In other words, the system accepts as a threshold only a predetermined number of values lying between a lower limit and an upper limit. Preferably, the threshold is a value between 1 and 10, wherein 1 is used for a low signal strength and hence for selecting also radio stations with poor reception quality, and 10 is used for a high signal strength and hence for radio stations having a high reception quality.

In a further preferred embodiment, the threshold-adjustment device is configured to adjust the threshold dependent on the signal strength of the currently selected radio station.

This feature means that the user may not choose a threshold value directly, but selects the threshold indirectly via the radio station currently played. Preferably, the user operates a rotary push button switch for selecting a radio station to be played and operates this rotary push button switch again to set the threshold to the value assigned to the played radio station.

These measures have the advantage that the operation of the car radio system, particularly the setting of the threshold, is easy and more convenient for the user.

In a preferred embodiment, a memory device adapted to store a value for each received radio station relating to the signal strength thereof is provided. Further, the selection device is adapted to display the name of all radio stations on the display and to mark those stations which signal strength is less than the adjusted threshold.

This measure allows to use radio stations for setting the threshold which would actually be filtered and hence not displayed. Due to that, the user may set the threshold on a lower value by selecting a radio station instead of inputting a threshold value directly.

The object of the present invention is also solved by a method for selecting and displaying the name of radio stations being receivable by a radio tuner, which comprises the steps of: determining the signal strength of each radio station received; adjusting a threshold relating to the signal strength; and displaying the name of those radio stations on the display having a signal strength greater than that threshold.

Preferably, the step of adjusting the threshold is performed by selecting a radio station. More preferably, the name of all receivable radio stations are displayed on the display which have a signal strength equal to or greater than the threshold.

Further, it is preferred that each received radio station is assigned a relative strength value relating to the determined absolute signal strength, wherein said strength value is selected out of a predetermined range of values, preferably integer values between 1 and 10.

The inventive method achieves the same advantages as the car radio system mentioned above, so that it is refrained from repeating these advantages here.

Further features and advantages can be taken from the following description and the enclosed drawings.

It is to be understood that the features mentioned above and those yet to be explained below can be used not only in the respective combinations indicated, but also in other combinations or in isolation, without leaving the scope of the present invention.

An embodiment of the invention is shown in the drawings and will be explained in more detail in the description below with reference to same. In the drawings:
- Fig. 1: is a schematic view of the front panel of a car radio system.
- Fig. 2: is a diagram showing a list of received radio stations;
- Fig. 3: is a schematic view of a display of the car radio system showing three menu items;
- Figs. 4A, B: are schematic diagrams of the display showing a menu for setting a threshold value;
- Fig. 5: is a schematic diagram of a filtered list of radio stations according to the set threshold;
- Fig. 6: is a table with radio stations and their assigned relative strength values;
- Figs. 7A, B: are schematic diagrams of the display showing a radio station list for selecting a station and for setting a threshold;
- Fig. 8: is a table as shown in Fig. 6, however, with a different threshold set; and
- Fig. 9: is a schematic diagram of the car radio system.

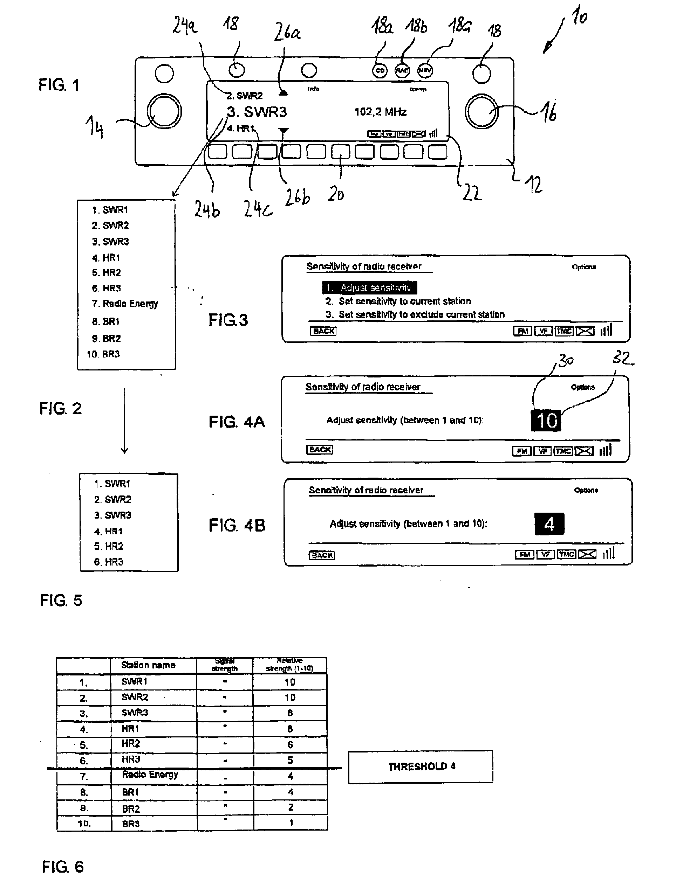

In Fig. 1 a front panel 12 of a car radio system 10 is schematically shown. The car radio system 10 is designed as a device which fits into the standardized installation slot in the dashboard of a vehicle. In addition to the device disposed in the dashboard, generally a further device is placed within the vehicle, for example in the glove compartment. The second device is the so-called GSM/GPS box offering navigation and telecommunication services. The GSM/GPS box is electrically connected with the device in the dashboard. In such a case, the car radio system 10 may also be referenced as a car multimedia system since it offers more than just radio (or more generally audio) functions. The present invention, however, may be employed in a car radio system as well as a car multimedia system.

Both devices have a plurality of connectors allowing to connect necessary hardware, like earphone, GSM antenna, GPS antenna, radio antenna, hands-free microphone, loudspeaker, etc. For the sake of simplicity, these parts are not shown in Fig. 1.

The car radio system 10 offers at least radio functions which may be selected via the front panel 12. If the car radio system is equipped with more functions, these functions may as well be selected via the front panel 12.

The front panel 12 comprises a first rotary push button switch 14 which allows to control the volume by rotating the rotary push button 14 and to switch on and off the car radio system 10 by pushing the rotary push button switch 14. The rotary push button switch 14 is placed on the left-hand side of the front panel 12. On the right-hand side, a second rotary push button switch 16 is provided which allows to select a menu item by rotating and to activate it by pushing the rotary push button 16. Hence, this switch 16 is used to carry out settings of the car radio system, for example.

Further selection keys in form of push button switches 18 are provided in the upper front panel area. Three of these selection keys are referenced with reference numeral 18a, 18b and 18c. The selection keys 18 serve to select a predetermined function of the car radio system 10, in the present case the CD function with selection key 18a, the radio function with the selection key 18b and optionally the navigation function with selection key 18c if this function is provided. Generally, such selection keys provided for selecting one specific function are called "hard keys".

In addition to these hard keys, the front panel 12 also carries so-called soft keys 20. These soft keys serve to select variable functions depending on the mode in which the car radio system is operated. In the present embodiment, ten soft keys are provided in the lower margin area of the front panel 12.

In the center of the front panel 12, a display 22 is disposed. In the present embodiment, the display 22 is a dot matrix display which allows to display several lines of information in form of characters, words or pictures, icons or pictograms.

In Fig. 1, the display 22 displays three lines of information in form of three different menu items 24a, 24b and 24c. The menu item shown in the middle line 24b is displayed with a larger font compared to the information shown at the first and third lines, 24a, 24c. The larger font indicates that the menu item in line 24b is also a status information informing about the currently selected radio station.

Further, the display 22 displays two arrows 26a, 26b, the upper arrow 26a being directed downwards and the lower arrow 26b being directed downwards. Both arrows indicate that more items than displayed are reachable.

The user may select a menu item by rotating the rotary push button 16 until the desired menu item is displayed in the middle line 24b. In order to activate this selected menu item, the users then have to push the rotary push button 16. Depending on the selected and activated menu item, either further menu items are displayed or the desired function is started. In the present embodiment shown in Fig. 1, the selection and activation of the menu item in the middle line 24b would result in setting and hence playing the respective radio station "SWR 3".

In Fig. 2, a list of radio stations is shown. These radio stations may be reached by operating the rotary push button switch 16. As it is known in the art, most of the radio stations transmit an information indicating the name of the radio station. In the embodiment shown in Fig. 1, the radio station transmitting on the frequency 102,2 MHz has the name "SWR 3". This type of radio station identification is called "RDS". This function makes the selection of a radio station easier compared to the selection on the basis of the radio frequency only.

The car radio system 10 receives a plurality of different radio stations each transmitting on a different radio frequency. These radio stations are received with different signal strengths so that the reception quality varies between different radio stations. Hence, there are radio stations with a very good reception quality and there are as well radio stations with a poor reception quality. In Fig. 2, all radio stations received by the car radio system 10 are listed. Further, the list is ordered with respect to the reception quality beginning with the highest reception quality and ending with the lowest reception quality. That is, the radio station "SWR 1" is received with the best reception quality and the radio station "BR 3" is received with the poorest reception quality.

Normally, the user does not select radio stations with poor reception quality since the car radio system then plays quite a lot of interferences and other unwanted signals. Further, such radio stations may not be played in a stereo mode.

Therefore, the car radio system makes a "pre-selection" of radio stations which may be played with a predetermined quality. In other words, the car radio system filters the list of received radio stations on the basis of the radio station signal strength which is a direct indication of the quality. In contrast to prior solutions, according to the present invention this filter is adjustable meaning that the user may adjust a threshold value. This threshold value (briefly threshold) defines a limit of a signal strength (and hence a reception quality) below which the radio stations are filtered and not displayed.

As already mentioned, this threshold may be adjusted by the user. The user has to select a menu, for example called "Sensitivity of radio receiver", which is shown in Fig. 3. The menu comprises three menu items, namely "Adjust sensitivity", "Set sensitivity to current station", and "Set sensitivity to exclude current station". The functions which may be performed by activating one of these menu items are now described with reference to Figs. 4 to 8.

If the user selects the first menu item "Adjust sensitivity", the menu as shown in Fig. 4a is displayed on the display 22. In the right portion of the display, a field 30 is displayed. This field 30 comprises a value 32 which is the currently set threshold. In the present embodiment shown in Fig. 4a, this threshold is 10. By turning the rotary push button switch 16, this value may be changed within a range of to 10. As shown in Fig. 4b, the threshold has been set to a value of 4. To activate this selection and hence to replace the currently set threshold with the new threshold, the user has to push the rotary push button switch 16.

As a result, the list of radio stations shown in Fig. 2 is reduced to those radio stations shown in Fig. 5. These radio stations all have a signal strength greater than the set threshold of 4.

As it is shown in Fig. 6, each radio station is assigned a value between 1 and 10 defining a relative strength of the measured absolute signal strength. The use of such relative values makes the adjustment of a threshold easier and more comprehensible.

A relative strength value of 10 represents a radio station with a very high signal strength, whereas a relative strength value of 1 represents a radio station with a very low signal strength. In the present embodiment, the radio station "SWR 1" is assigned a relative strength value of 10 and the radio station "BR 3" is assigned a relative strength value of 1. If a threshold of 4 is selected by the user, all radio stations with a relative strength value greater than 4 are displayed in the radio station list and all remaining radio stations received by the car radio system 10 are suppressed and not displayed. This boundary is shown in Fig. 6 by way of a bold line between the radio stations "HR 3" and "Radio Energy".

Of course it is apparent for a man skilled in the art that the filter as an alternative may be configured such that also the radio stations with a relative strength value equal to the set threshold are displayed and hence are part of the radio station list.

A further way to adjust the threshold may be achieved by selecting and activating the menu item "Set sensitivity to current station", shown in Fig. 3. In response to this activation, the car radio system 10 replaces the threshold currently set with the relative strength value assigned to the currently played radio station. With respect to the present embodiment, the threshold is set to a value of 8, since the currently played radio station is "SWR 3", having a relative strength value of 8, as shown in Fig. 6. As a result, the list of radio stations would be reduced to the first four stations, namely SWR 1, SWR 2, SWR 3 and HR 1, each having a relative strength value greater than or equal to 8.

A third alternative for setting the threshold may be performed by selecting and activating the third menu item "Set sensitivity to exclude current station", as shown in Fig. 3. This alternative equals the second alternative described above with the exception that only those radio stations are displayed which have a relative strength value greater than (and not equal to) the threshold value. In the present embodiment, the current station is "SWR 3", the new threshold is 8. Hence, only the radio stations SWR 1 and SWR 2 are displayed since their relative strength value is greater than 8.

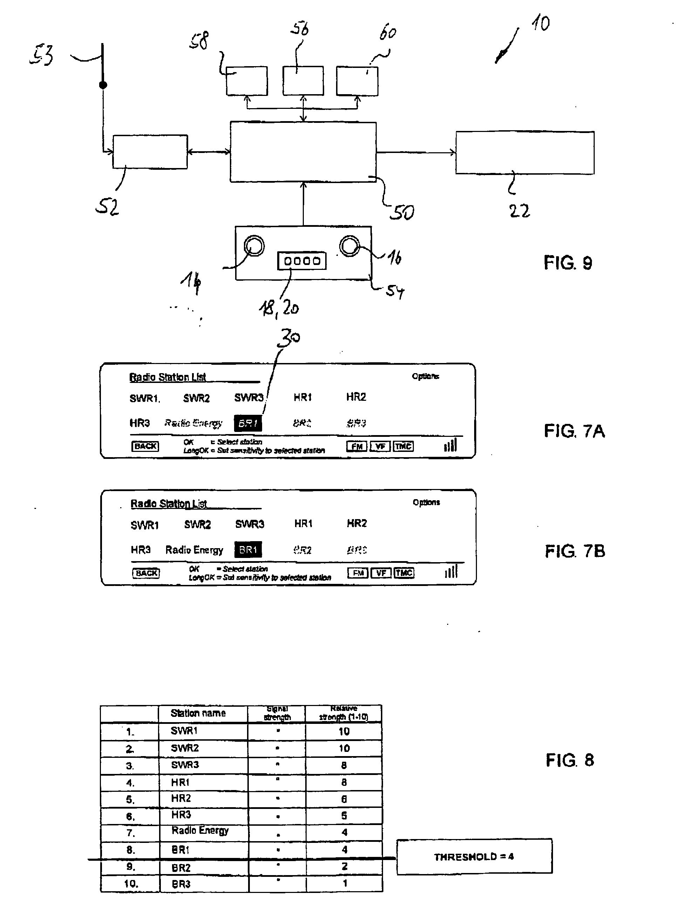

A further alternative for setting a threshold is now described with reference to Figs. 7 and 8.

In Fig. 7a, a menu "Radio Station List" is displayed which is normally used for selecting a radio station. In contrast to the radio station list displayed in Fig. 1, all radio stations received by the radio tuner are displayed in rows and columns. Even the radio stations having a relative strength value below the actual threshold are displayed, however, in Italic and gray characters. With reference to Fig. 7a, the radio stations SWR 1 to HR 3 are radio stations above the threshold, and radio stations Radio Energy, BR 1, BR 2 and BR 3 are radio stations below the threshold.

The displayed menu now allows the user also to select radio stations below the threshold by moving the cursor 30 on the respective radio station name and by confirming this selection. Both operations, that is moving the cursor and confirming the selection, are performed by using the rotary push button switch 16.

If the user wants to set a new threshold, he moves the cursor 30 on a station name and performs a "long confirmation" by pushing the rotary push button switch 16 for a longer period. The new threshold is than the relative strength value assigned to the selected radio station. The car radio system is adapted to distinguish between a normal confirmation and a long confirmation and performs in the first case the selection of a radio station and in the second case the setting of a new threshold.

With reference to Fig. 7a, the new threshold is four, since the selected radio station BR 1 has a relative strength value of four. In response to the setting of a new threshold, the radio station list is modified such that only the radio stations BR 1 and BR 3 are displayed with Italic and gray characters . All other radio stations have a relative strength value greater than or equal to the set threshold of four.

It is apparent for a skilled person that the relative strength value assigned to the radio stations are continuously checked and adapted to the varying signal strength of the radio stations during operation of the car radio system.

In Fig. 9 a block diagram of the car radio system 10 is schematically shown. The car radio system 10 comprises a central controller 50 which is coupled with a radio tuner 52. A radio antenna 53 is connected with the radio tuner 52 and adapted to receive radio signals in different wavebands. As already mentioned before, the car radio system 10 also comprises a display 22 which is driven by the central controller 50. Further, the central controller 50 receives input from a control element unit 54 which comprises both rotary push button switches 14, 16 and a plurality of hard keys and soft keys 18, 20.

The central controller 50 is also coupled with a memory device 56 for storing radio stations, a threshold adjusting device 58 and a selection device 60.

The threshold-adjusting device is adapted to perform the above-described method to adjust the threshold value. Particularly, the threshold-adjusting device continuously assigns relative strength values to each received radio station. Further, the device 58 replaces the current threshold value with the relative strength value of the currently played radio station, if requested by the system.

The selection device 60 is adapted to continuously perform a filtering of all radio stations received as to display only those radio stations having a relative strength value greater than (or equal to) the set threshold.

Those skilled in the art can now appreciate from the foregoing description that the broad teachings of the present invention can be implemented in a variety of forms. Therefore, while this invention has been described in connection with a particular example thereof, the true scope of the invention should not be so limited since other modifications will become apparent to the skilled practitioner upon a study of the drawings, specification and the claims.

Particularly, the skilled person knows that the threshold-adjusting device 58 and the selection device 60 may be integrated with the central controller 50.

## Claims

1. Car radio system comprising:
- a radio tuner device (52) for receiving a plurality of different radio stations each having a specific signal strength, and
- a radio station selection device (60) for selecting radio stations with a signal strength above a predetermined threshold and for displaying the name of the selected radio stations on a display,
**characterized by**
- a threshold-adjusting device (58) allowing to adjust said threshold manually.

2. Car radio system of claim 1, **characterized in that** said threshold-adjustment device (58) is assigned a control element (16) to allow step-adjustment of the threshold between a lower limit and an upper limit.

3. Car radio system of claim 1 or 2, **characterized in that** said threshold-adjustment device (58) is configured to adjust the threshold dependent on the signal strength of the currently selected radio station.

4. Car radio system of claim 2, **characterized in that** said control element is a rotary push button switch (16).

5. Car radio system of any of claims 1 through 4, **characterized by** a memory device (56) adapted to store a value for each received radio station relating to the signal strength thereof.

6. Car radio system of any of claims 1 through 5, **characterized in that** said selection device (60) is adapted to display the name of all radio stations on the display (22) and to mark those stations which signal strength is less than the adjusted threshold.

7. Method for selecting and displaying radio stations being receivable by a radio tuner, comprising the steps of:
- determining the signal strength of each radio station received;
- adjusting a threshold relating to the signal strength; and
- displaying the name of those radio stations on the display having a signal strength greater than said threshold.

8. Method of claim 7, wherein said step of adjusting said threshold is performed by selecting a radio station.

9. Method of claim 7 or 8, wherein the name of all receivable radio stations is displayed on the display which have a signal strength equal to or greater than said threshold.

10. Method of claim 7, wherein each received radio station is assigned a relative strength value relating to the determined absolute signal strength, wherein said strength value is selected from a predetermined range of values.

## Patentansprüche

1. Autoradiosystem, umfassend:
- eine Radioempfängervorrichtung (52) zum Empfangen mehrerer unterschiedlicher Radiostationen, welche jeweils eine spezielle Signalstärke aufweisen, und
- eine Radiostationauswahlvorrichtung (60) zum Auswählen von Radiostationen mit einer Signalstärke über einem vorbestimmten Schwellenwert und zum Anzeigen des Namens der gewählten Radiostationen auf einer Anzeige,
**gekennzeichnet durch**
- eine Schwellenwerteinstellvorrichtung (58), welche ermöglicht, den Schwellenwert manuell einzustellen.

2. Autoradiosystem nach Anspruch 1, **dadurch gekennzeichnet, dass** der Schwellenwerteinstellvorrichtung (58) ein Steuerelement (16) zugeordnet ist, um eine Stufeneinstellung des Schwellenwerts zwischen einem unteren Grenzwert und einem oberen Grenzwert zu ermöglichen.

3. Autoradiosystem nach Anspruch 1 oder 2, **dadurch gekennzeichnet, dass** die Schwellenwerteinstellvorrichtung (58) ausgestaltet ist, den Schwellenwert in Abhängigkeit von der Signalstärke der gegenwärtig ausgewählten Radiostation einzustellen.

4. Autoradiosystem nach Anspruch 2, **dadurch gekennzeichnet, dass** das Steuerelement ein Drehdruckknopfschalter (16) ist.

5. Autoradiosystem nach einem der Ansprüche 1 bis 4, **gekennzeichnet durch** eine Speichervorrichtung (56), welche ausgestaltet ist, einen Wert für jede empfangene Radiostation zu speichern, welcher die Signalstärke davon betrifft.

6. Autoradiosystem nach einem der Ansprüche 1 bis 5, **dadurch gekennzeichnet, dass** die Auswahlvorrichtung (60) ausgestaltet ist, die Namen von allen Radiostationen auf der Anzeige (22) anzuzeigen und diejenigen Stationen zu markieren, deren Signalstärke kleiner als der eingestellte Schwellenwert ist.

7. Verfahren zum Auswählen und Anzeigen von Radiostationen, welche von einem Radioempfänger empfangbar sind, umfassend die Schritte:
- Bestimmen der Signalstärke einer jeden empfangenen Radiostation;
- Einstellen eines Schwellenwerts, welcher die Signalstärke betrifft; und
- Anzeigen der Namen von denjenigen Radiostationen auf der Anzeige, welche eine Signalstärke größer als der Schwellenwert aufweisen.

8. Verfahren nach Anspruch 7, wobei der Schritt des Einstellens des Schwellenwerts durch Auswählen einer Radiostation durchgeführt wird.

9. Verfahren nach Anspruch 7 oder 8, wobei die Namen von allen empfangbaren Radiostationen auf der Anzeige angezeigt werden, welche eine Signalstärke gleich dem Schwellenwert oder größer als der Schwellenwert aufweisen.

10. Verfahren nach Anspruch 7, wobei jeder empfangenen Radiostation ein relativer Stärkenwert zugeordnet wird, welcher sich auf die bestimmte absolute Signalstärke bezieht, wobei der Stärkenwert aus einem vorbestimmten Bereich von Werten ausgewählt wird.

## Revendications

1. Système d'autoradio comprenant:
- un dispositif de tuner radio (52) destiné à recevoir une pluralité de stations radio différentes ayant chacune une intensité de signal spécifique, et
- un dispositif de sélection de station radio (60) destiné à sélectionner des stations radio ayant une intensité de signal supérieure à un seuil prédéterminé et à afficher le nom des stations radio sélectionnées sur un afficheur,
**caractérisé par**
- un dispositif d'ajustement de seuil (58) permettant d'ajuster ledit seuil manuellement.

2. Système d'autoradio selon la revendication 1, **caractérisé en ce que** ledit dispositif d'ajustement de seuil (58) se voit attribuer un élément de commande (16) permettant l'ajustement progressif du seuil entre une limite inférieure et une limite supérieure.

3. Système d'autoradio selon la revendication 1 ou 2, **caractérisé en ce que** ledit dispositif d'ajustement de seuil (58) est configuré afin d'ajuster le seuil selon l'intensité de signal de la station radio actuellement sélectionnée.

4. Système d'autoradio selon la revendication 2, **caractérisé en ce que** ledit élément de commande est un bouton-poussoir rotatif (16).

5. Système d'autoradio selon l'une quelconque des revendications 1 à 4, **caractérisé par** un dispositif de mémoire (56) adapté afin de stocker une valeur pour chaque station radio reçue liée à l'intensité de signal de celle-ci.

6. Système d'autoradio selon l'une quelconque des revendications 1 à 5, **caractérisé en ce que** ledit dispositif de sélection (60) est adapté afin d'afficher le nom de toutes les stations radio sur l'afficheur (22) et de marquer les stations dont l'intensité de signal est inférieure au seuil ajusté.

7. Procédé de sélection et d'affichage de stations radio pouvant être reçues par un tuner radio, comprenant les étapes consistant à:
- déterminer l'intensité de signal de chaque station radio reçue;
- ajuster un seuil lié à l'intensité de signal; et
- afficher le nom des stations radio ayant une intensité de signal supérieure audit seuil sur l'afficheur.

8. Procédé selon la revendication 7, dans lequel ladite étape d'ajustement dudit seuil est effectuée en sélectionnant une station radio.

9. Procédé selon la revendication 7 ou 8, dans lequel le nom de toutes les stations radio pouvant être reçues et qui possèdent une intensité de signal égale ou supérieure audit seuil est affiché sur l'afficheur.

10. Procédé selon la revendication 7, dans lequel chaque station radio reçue se voit attribuer une valeur d'intensité relative liée à l'intensité de signal absolue déterminée, où ladite valeur d'intensité est choisie parmi une plage de valeurs prédéterminée.
